# EUROPEAN PATENT APPLICATION

(11) **EP 4 134 163 A1**
(43) Date of publication of application: **15.02.2023**
(21) Application number: 21785435.5
(22) Date of filing: 31.03.2021
(51) Int. Cl.: B01J 37/02, B01J 23/42, C23C 16/455, C23C 16/44, C23C 16/40, B01D 53/86

(54) **METHOD FOR PRODUCING METAL CATALYST HAVING INORGANIC FILM DEPOSITED THEREON BY MEANS OF ALD PROCESS, AND METAL CATALYST HAVING IMPROVED ACTIVITY ACCORDING THERETO**

(30) Priority: 08.04.2020 KR 20200042648
(71) Applicant: Hanwha Solutions Corporation, Jung-gu Seoul 04541 (KR); Korea Advanced Institute of Science and Technology, Daejeon 34141 (KR)
(72) Inventor: CHO, Young Jin, Daejeon 34128 (KR); KIM, Do Heung, Daejeon 34128 (KR); WOO, Eun Ji, Daejeon 34128 (KR); JANG, Won Tae, Daejeon 34141 (KR); CHOI, Keon Woo, Daejeon 34141 (KR); IM, Sung Gap, Daejeon 34141 (KR)
(74) Representative: Klunker IP Patentanwälte PartG mbB
(86) International application number: PCT/KR2021/003977
(87) International publication number: WO 2021/206357

(57) **Abstract**

The present invention relates to a method for producing a metal catalyst having an inorganic film deposited thereon by means of an atomic layer deposition (ALD) process, and to a metal catalyst according thereto. More specifically, the method includes a step of inducing selective adsorption of reactants to a portion having a low coordination number on the surface of the catalyst in the ALD process, thereby being intended to induce interaction between the catalyst and an inorganic film layer and maximally secure active sites of the catalyst.

## Description

### TECHNICAL FIELD

The present invention relates to a method for producing a metal catalyst having an inorganic film deposited thereon by means of an atomic layer deposition (ALD) process, and to a metal catalyst having improved activity according thereto. More specifically, the method includes a step of inducing selective adsorption of reactants to a portion having a low coordination number on the surface of the catalyst in the ALD process, thereby being intended to induce interaction between the catalyst and an inorganic film layer and maximally secure active sites of the catalyst.

### BACKGROUND ART

Atomic layer deposition (ALD) refers to a deposition method for growing a thin film in units of atomic layers. In the case of general chemical vapor deposition, precursors are injected at the same time and a surface reaction is performed together with a gas phase reaction. However, in the case of ALD, a vapor phase reaction is suppressed through sequential injection of reactants and deposition is performed by a surface reaction through self-limited adsorption on a surface of a deposition target. Since the thickness of the entire deposited film is controlled through the number of deposition cycles, there is an advantage that can easily control the thickness in units of atomic layers. In addition, due to various types, good thin film properties, and excellent properties of processing or the like even at relatively low temperatures, development has been made by mainly applying to semiconductor dielectrics, magnetic materials, and the like. However, with the recent development of nanotechnology, the ALD of oxides has been actively studied in various fields in recent years, departing from the trend of research focusing on traditional integrated circuit devices. In particular, specific studies to apply to metal thin film coating of catalysts are currently actively in progress.

For example, Korean Patent Publication No. 10-2008-0057542 relates to an oxidation catalyst used in a method for removing carbon monoxide contained in exhaust gas, the method including remove an alkali component from the exhaust gas by contacting the exhaust gas with powdered activated carbon, and removing CO from the exhaust gas by contacting a CO oxidation catalyst, from which the alkali component has been removed, with a CO oxidation catalyst. Therefore, it is disclosed that there is no problem of catalyst poisoning caused by sulfur oxides or alkali materials contained in the exhaust gas, and thus, carbon monoxide can be removed more effectively.

Next, as non-patent literature, a paper, J. Phys. Chem. C 2016. 120. No. 1 discloses a technique for improving activity by depositing a TiO₂ thin film on an Au catalyst according to an ALD process. It is disclosed that the activity increases as the interface between Au and TiO₂ increases. It is disclosed that, up to 20 cycles, the activity increases as the interface increases, and at higher cycles, the activity decreases as the activity of Au is blocked.

Finally, as non-patent literature, a paper, ACS Catal. 2015. 2 discloses that Al₂O₃/TiO₂ as a support is mixed with a Pt catalyst. It is disclosed that Al₂O₃ provides thermal stability and high surface area, and TiO₂ improves dispersibility through strong-metal-support-interaction (SMSI). In addition, it is disclosed that TiO₂ forms SMSI with Pt to increase the electron density of Pt, thereby facilitating the desorption of propane and reducing an coking issue. However, it was confirmed that, when the ratio of TiO₂ exceeds 20%, the adsorption amount of propane is rather reduced and both activity and stability are reduced.

As described above, various research and development have been conducted into the metal catalysts having the thin film coated thereon by using the ALD process. As part of these studies, the present invention has been completed to increase catalytic activity by inducing selective adsorption of reactants to a portion having a low coordination number of a catalyst in an ALD process.

### [Citation List]

(Patent Literature 1) Korean Patent Publication No. 10-2008-0057542 (2012.12.06)
(Non-Patent Literature 2) J. Phys. Chem. C 2016, 120, no.1, 478-486
(Non-Patent Literature 3) ACS Catal. 2015, 5, 438-447 571-577

### DESCRIPTION OF EMBODIMENTS

### TECHNICAL PROBLEM

The present invention aims to solve the above-described problems.

An object of the present invention is to improve catalytic activity by selectively depositing an inorganic film on a portion having a low coordination number on a surface of a catalyst through an atomic layer deposition (ALD) process.

An object of the present invention is to maximally secure active sites of a catalyst and secure process conditions that induce interaction between the catalyst and an inorganic film layer.

### SOLUTION TO PROBLEM

In order to achieve the above-described objects of the present invention and realize the characteristic effects of the present invention described below, the characteristic configuration of the present invention is as follows.

According to an embodiment of the present invention, a method for producing a metal catalyst having an inorganic film deposited thereon by means of an atomic layer deposition (ALD) process includes: (a) injecting a precursor into a supported catalyst using ALD to induce selective adsorption of the precursor to a portion having a low coordination number on a surface of a catalyst; (b) performing purging; (c) depositing an inorganic film by injecting an oxidizing agent and reacting the oxidizing agent with the precursor selectively adsorbed on the surface of the catalyst; and (d) performing purging.

According to an embodiment of the present invention, the catalyst in the step (a) is at least one selected from platinum (Pt), gold (Au), silver (Ag), copper (Cu), nickel (Ni), palladium (Pd), rhodium (Rh), and ruthenium (Ru).

According to an embodiment of the present invention, the supporting in the step (a) provides at least one selected from alumina, silica, zeolite, titania, zirconia, and carbon as a support.

According to an embodiment of the present invention, the precursor in the step (a) is at least one precursor selected from titanium (Ti), aluminum (Al), zinc (Zn), zirconium (Zr), and cerium (Ce).

According to an embodiment of the present invention, the inducing of the selective adsorption in the step (a) is controlled by adjusting an injection time, a substrate temperature, and a process cycle.

According to an embodiment of the present invention, the oxidizing agent in the step (c) is at least one selected from ultra-pure purified water, alcohol, ozone, nitrous oxide, and oxygen.

According to an embodiment of the present invention, a time necessary for injecting the oxidant in the step (c) is 0.5 seconds to 30 seconds.

According to an embodiment of the present invention, an injection time of the injecting in the steps (a) and (c) is 0.5 seconds to 30 seconds.

According to an embodiment of the present invention, the injecting in the steps (a) and (c) is performed by injecting an inert gas as a carrier gas.

According to an embodiment of the present invention, the purging in the steps (b) and (d) is performed by injecting an inert gas.

According to an embodiment of the present invention, the purging in the steps (b) and (d) is performed at a pressure of 0.001 to 1 torr.

According to an embodiment of the present invention, an atomic layer is deposited by performing the method 1 to 100 cycles.

According to an embodiment of the present invention, there is provided a metal catalyst having an inorganic film deposited thereon by means of an atomic layer deposition (ALD) process, the metal catalyst being produced by the above-described method. In this case, a thickness of the inorganic film is 0.1 nm to 2 nm.

According to an embodiment of the present invention, the metal catalyst is provided for a carbon monoxide oxidation reaction.

### ADVANTAGEOUS EFFECTS OF DISCLOSURE

According to the present invention, an inorganic film may be deposited according to an atomic layer deposition (ALD) process, thereby improving activity of a catalyst.

In particular, selective adsorption of a precursor may be induced to a portion having a low coordination number in a catalyst, thereby improving the interface with the catalyst surface and improving activity.

According to the present invention, different degrees of activity improvement may be provided according to ALD process conditions.

### BRIEF DESCRIPTION OF DRAWINGS

FIG. 1 shows steps (a) and (c) of an atomic layer deposition (ALD) process according to the present invention.
FIG. 2 shows a result of measuring catalytic activity at 150°C in Examples 1 and 2 of the present invention and Comparative Example.
FIG. 3 shows a result of measuring catalytic activity at 160°C in Examples 1 and 2 of to the present invention and Comparative Example.
FIG. 4 shows a result of measuring catalytic activity according to a temperature of a metal catalyst using γ-Al₂O₃ as a support in Examples 1 and 2 of the present invention and Comparative Example.
FIG. 5 shows a result of measuring catalytic activity according to a temperature of a metal catalyst using α-Al₂O₃ as a support in Examples 4 to 7 of the present invention and Comparative Example.

### MODE OF DISCLOSURE

Reference is made to the accompanying drawing which shows, by way of illustration, specific embodiments in which the present invention may be practiced. The embodiments will be described in detail in such a manner that the present invention can be carried out by those of ordinary skill in the art. It should be understood that various embodiments of the present invention are different from each other, but need not be mutually exclusive. For example, certain shapes, structures, and features described herein may be implemented in other embodiments without departing from the spirit and scope of the present invention in connection with one embodiment. In addition, it will be understood that the locations or arrangement of individual components in the disclosed embodiments can be changed without departing from the spirit and scope of the present invention. Therefore, the following detailed description is not to be taken in a limiting sense, and the scope of the present invention is to be limited only by the appended claims and the entire scope of equivalents thereof, if properly explained.

Hereinafter, preferred embodiments of the present invention will be described in detail with reference to the accompanying drawing, so that those of ordinary skill in the art can easily carry out the present invention.

According to an embodiment of the present invention, atomic layer deposition (ALD) refers to a deposition method for growing a thin film on a surface of a catalyst in units of atomic layers. A method for producing a catalyst having an inorganic film coated thereon by using ALD is provided.

According to an embodiment of the present invention, a method for producing a metal catalyst having an inorganic film deposited thereon by means of an atomic layer deposition (ALD) process includes: (a) injecting a precursor into a supported catalyst using ALD to induce selective adsorption of the precursor to a portion having a low coordination number on a surface of a catalyst; (b) performing purging; (c) depositing an inorganic film by injecting an oxidizing agent and reacting the oxidizing agent with the precursor selectively adsorbed on the surface of the catalyst; and (d) performing purging.

According to an embodiment of the present invention, the catalyst in the step (a) may be at least one selected from platinum (Pt), gold (Au), silver (Ag), copper (Cu), nickel (Ni), palladium (Pd), rhodium (Rh), and ruthenium (Ru). Preferably, the catalyst may be platinum (Pt).

According to an embodiment of the present invention, a support provided in the supporting in the step (a) may be at least one selected from alumina (Al₂O₃), silica (SiO₂), titania (TiO₂), zirconia (ZrO₂), zeolite, and carbon as a support. Preferably, the catalyst may be supported in an alumina (Al₂O₃) support. In this case, the provided alumina (Al₂O₃) support may be alpha-alumina (α-Al₂O₃) or gamma-alumina (γ-Al₂O₃), but is not limited thereto.

The carbon support is not particularly limited, but at least one selected from activated carbon, carbon black, graphite, graphene, ordered mesoporous carbon (OMC), and carbon nanotubes may be used.

The supporting includes impregnation or immersion. A specific surface area of the provided support may be measured by a commonly used BET method, and may be 5 to 300 m²/g. Accordingly, thermal stability can be ensured and sufficient dispersion and catalytic activity can be provided.

According to an embodiment of the present invention, the precursor may be at least one precursor selected from titanium (Ti), aluminum (Al), zinc (Zn), zirconium (Zr), and cerium (Ce). Preferably, the titanium (Ti) precursor may be provided.

For example, the titanium precursor may be tetrakis dimethylamido titanium, tetrakis diethylamido titanium, titanium tetraisopropoxide, titanium tetrachloride, titanium nitrate, or titanium sulfate, but is not limited thereto.

As another example, the alumina precursor may be an organoaluminum compound, for example, triisobutyl aluminum, dimethyl aluminum hydride, triethyl aluminum, trimethyl aluminum, and the like. The aluminum precursor may be provided in the form of a hydride and a complex salt, but is not limited thereto.

According to an embodiment of the present invention, the inducing of the selective adsorption in the step (a) is controlled by adjusting an injection time, a substrate temperature, and a process cycle.

According to an embodiment of the present invention, in order to induce the selective adsorption, the injecting in the step (a) is performed for 0.5 seconds to 30 seconds. Preferably, the reaction time of the catalyst and the precursor injected for 10 to 20 seconds may be sufficiently provided, and a selective adsorption effect may be provided.

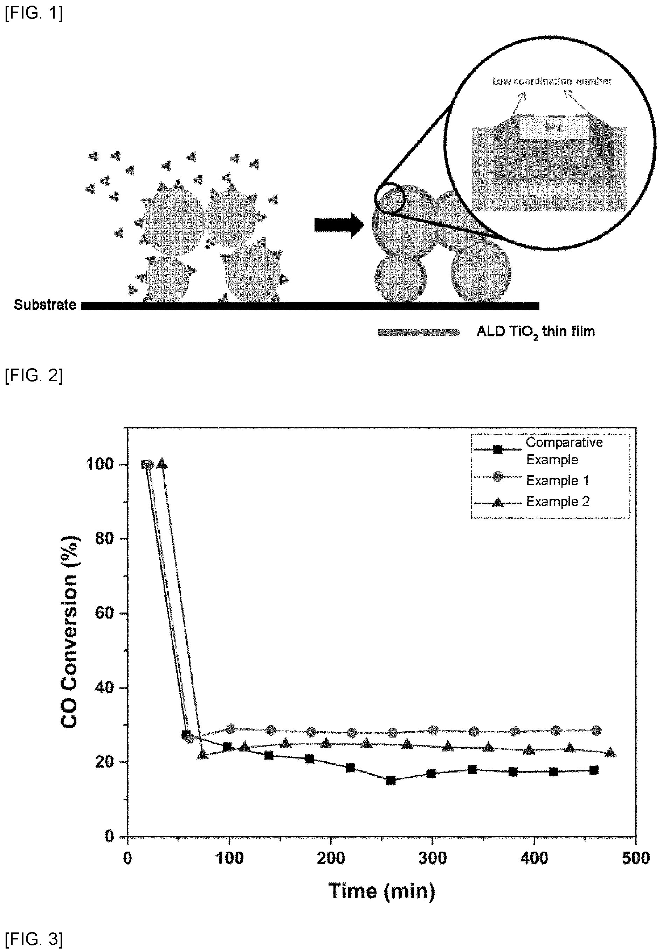

After the injecting, a step of inducing selective adsorption of the precursor to a portion having a low coordination number on the surface of the catalyst is performed. The low coordination number refers to a portion where adsorption occurs well in the metal catalyst. For example, the interface may be increased by inducing the selective adsorption of the titania precursor only to a portion having a low coordination number in the platinum (Pt) catalyst supported on the support, thereby improving the activity of the catalyst. This can be seen from FIG. 1.

According to an embodiment of the present invention, in order to induce the selective adsorption, the temperature of the substrate is provided at 100 to 200°C. The substrate refers to a reaction substrate on which a catalyst to be deposited is mounted. In order to cause the selective adsorption by providing the temperature, the adsorption to a portion having a low coordination number is induced, thereby securing a sufficient interface and securing sufficient active sites. The cycle of the process will be described below.

According to an embodiment of the present invention, the injecting in the steps (a) and (c) is performed by injecting an inert gas as a carrier gas. The provided inert gas may be, for example, nitrogen, helium, neon, argon, and the like, but is not limited thereto.

According to an embodiment of the present invention, after the step (a), a step (b) of performing purging is provided. The purging means purification or removal. For example, the inert gas may be injected to provide an internal pressure of 0.001 to 1 torr. When the pressure exceeds 1 torr, it may mean that reactive precursors or purging gas remain. Accordingly, adsorption of additional reactants can be prevented by adjusting the pressure of the provided gas. The inert gas may be, for example, nitrogen, helium, neon, argon, and the like, but is not limited thereto.

According to an embodiment of the present invention, a step (c) of depositing an inorganic film by injecting an oxidizing agent and reacting the oxidizing agent with the precursor selectively adsorbed on the surface of the catalyst is provided. This can be seen from FIG. 1. In this case, the provided oxidizing agent may be at least one selected from ultra-pure purified water, alcohol, ozone, nitrous oxide, and oxygen. Preferably, ultra-pure purified water may be provided.

According to an embodiment of the present invention, a time necessary for injecting the oxidant in the step (c) is 0.5 seconds to 30 seconds. By providing the injection time within the above range, the reaction is performed with the precursor selectively adsorbed on the surface of the catalyst to finally selectively deposit the inorganic film on the surface of the catalyst, thereby improving the activity of the catalyst.

According to an embodiment of the present invention, after the step (c), a step (d) of performing purging is provided. This case is the same as the contents provided in the step (b).

According to an embodiment of the present invention, an atomic layer may be deposited by performing the method 1 to 100 cycles. Preferably, 10 to 50 cycles may be provided. One cycle means a series of flows of the steps (a) to (d).

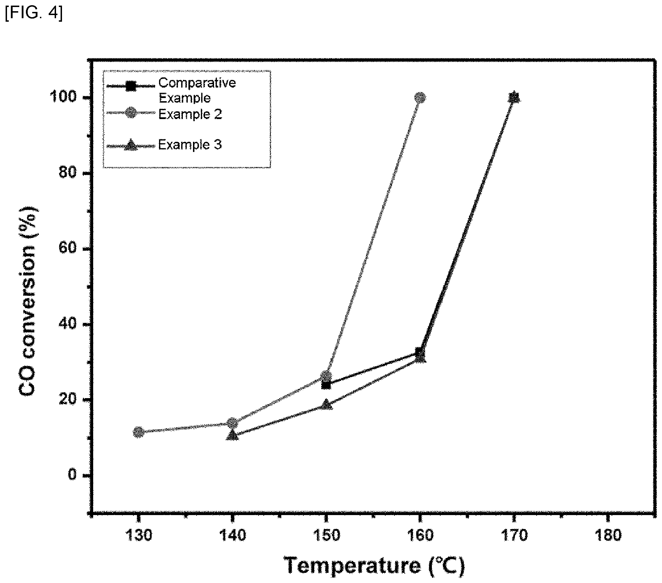

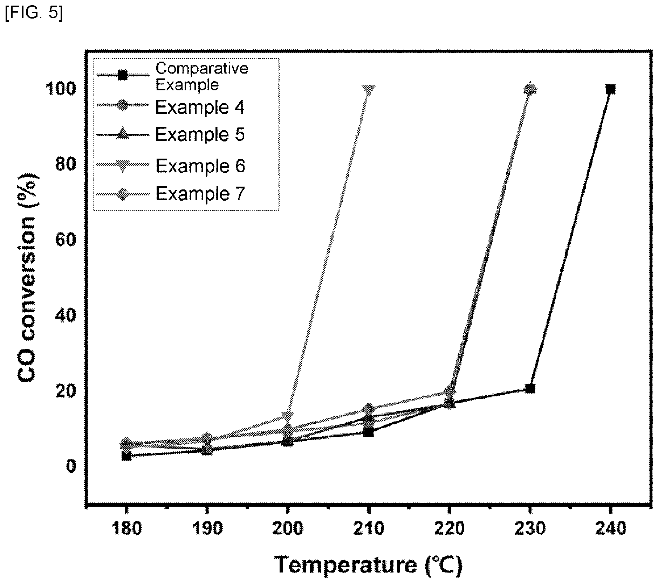

The cycle process may be slightly different according to the type of the supported catalyst. For example, Pt/γ-Al₂O₃ may show high activity when 10 cycles are provided, and Pt/α-Al₂O₃ may show high activity may 50 cycles are provided. Therefore, the process conditions can be appropriately adjusted according to the supported catalyst. In addition, since the effect of improving the activity by inducing selective adsorption is different, the activity can be adjusted as necessary. This can be confirmed from FIGS. 4 and 5.

According to an embodiment of the present invention, there is provided a metal catalyst having an inorganic film deposited thereon by means of an ALD process, the metal catalyst being produced by the above-described method. Hereinafter, the same description as that of the method for producing the catalyst may be applied, and redundant descriptions will be omitted.

According to an embodiment of the present invention, the organic film may be deposited to a thickness of 0.1 nm to 2 nm. More specifically, the thickness deposited by one cycle may be 0.02 nm to 0.1 nm. Accordingly, by adjusting the number of cycles or repeating the cycles, the thickness of the inorganic film can be freely and appropriately modified at the level of those or ordinary skill in the art as necessary.

According to an embodiment of the present invention, the catalyst according to the present invention may be in the form of powder, particles, granules, and pellets. Preferably, the catalyst according to the present invention may be provided in the form of powder or particles.

According to an embodiment of the present invention, the metal catalyst may be applied to a carbon monoxide oxidation reaction. In particular, in the carbon monoxide oxidation reaction that is performed at a high temperature of 100°C to 300°C, it is possible to provide effects such as high catalytic activity of the catalyst and prevention of sintering.

Hereinafter, the structure and operation of the present invention will be described in more detail with reference to preferred examples of the present invention. However, these examples are shown by way of illustration and should not be construed as limiting the present invention in any sense. Since contents not described herein can be sufficiently technically inferred by those of ordinary skill in the art, descriptions thereof will be omitted.

### Example 1

A supported catalyst was placed on a substrate at 150°C for surface deposition of a catalyst. As the supported catalyst, a γ-Al₂O₃-supported platinum (Pt) catalyst was used. Titanium tetraisopropoxide (TTIP) (99.999%, EG Chem, Co. Ltd.) was provided as a precursor to induce selective adsorption to a portion having a low coordination number on a surface of a catalyst, and then was purged for 600 seconds in a condition of 150°C and 1 torr.

Thereafter, ultra-pure purified water serving as an oxidizing agent was injected at 150°C and 1 torr for 15 seconds. TiO₂ was deposited to a thickness of 0.1 nm on the surface of the supported catalyst by purging for 600 seconds in a condition of 150°C and 1 torr. This was defined as one cycle of an ALD process.

The above process was repeated for four more cycles to finally produce a platinum catalyst (5 cycle TiO₂ coated Pt/γ-Al₂O₃) on which an inorganic film coated with TiO₂ was deposited.

### Example 2

Example 2 was produced in the same manner as Example 1, except that an ALD process was performed for 10 cycles to produce a platinum catalyst (10 cycle TiO₂ coated Pt/γ-Al₂O₃) on which an inorganic film coated with TiO₂ was deposited.

### Example 3

Example 3 was produced in the same manner as Example 1, except that an ALD process was performed for 50 cycles to produce a platinum catalyst (50 cycle TiO₂ coated Pt/γ-Al₂O₃) on which an inorganic film coated with TiO₂ was deposited.

### Example 4

A supported catalyst was placed on a substrate at 150°C for surface deposition of a catalyst. As the supported catalyst, an α-Al₂O₃-supported platinum (Pt) catalyst was used. Only TTIP was provided. Selective adsorption was induced to a portion having a low coordination number on the surface of the catalyst, and then was purged for 600 seconds in a condition of 150°C and 1 torr.

Thereafter, ultra-pure purified water serving as an oxidizing agent was injected at 150°C and 1 torr for 15 seconds. TiO₂ was deposited to a thickness of 0.1 nm on the surface of the supported catalyst by purging for 600 seconds in a condition of 150°C and 1 torr. This was defined as one cycle of an ALD process.

The above process was repeated for nine more cycles to finally produce a platinum catalyst (10 cycle TiO₂ coated Pt/α-Al₂O₃) on which an inorganic film coated with TiO₂ was deposited.

### Example 5

Example 5 was produced in the same manner as Example 4, except that an ALD process was performed for 30 cycles to produce a platinum catalyst (30 cycle TiO₂ coated Pt/α-Al₂O₃) on which an inorganic film coated with TiO₂ was deposited.

### Example 6

Example 6 was produced in the same manner as Example 4, except that an ALD process was performed for 50 cycles to produce a platinum catalyst (50 cycle TiO₂ coated Pt/α-Al₂O₃) on which an inorganic film coated with TiO₂ was deposited.

### Example 7

Example 7 was produced in the same manner as Example 4, except that an ALD process was performed for 100 cycles to produce a platinum catalyst (100 cycle TiO₂ coated Pt/α-Al₂O₃) on which an inorganic film coated with TiO₂ was deposited.

### Comparative Example

A platinum catalyst (Bare Pt/ γ-Al₂O₃) supported on an alumina support was produced without performing an ALD process.

### Experimental Example 1-1: Evaluation of activity of catalyst

In order to confirm the activity of the catalysts according to Examples 1 and 2 and Comparative Example, CO oxidation was performed at 150°C and CO conversions (%) over time were measured and compared. As reaction gas, 5% CO (background gas air) was flowed into a reactor in an amount of 40 ml/min. In addition, before the reaction, reduction was performed at 500°C for 3 hours by using 3.9% H₂ (background gas N₂), and then CO oxidation reaction was performed. The results thereof are shown in FIG. 2.

### Experimental Example 1-2: Evaluation of activity of catalyst

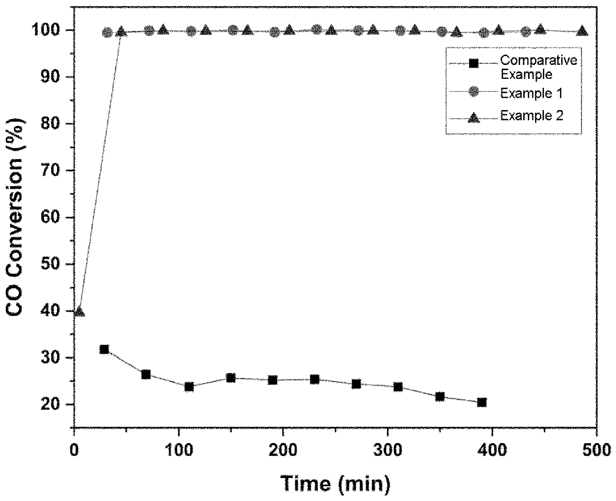

In order to confirm the activity of the catalysts according to Examples 1 and 2 and Comparative Example, CO oxidation (%) was performed at 160°C and CO conversions (%) over time were measured and compared. The results thereof are shown in FIG. 3.

### Experimental Example 1-3: Evaluation of activity of catalyst

In order to confirm the activity of the catalysts according to Examples 2 and 3 and Comparative Example, CO conversions (%) according to a temperature were measured. The results thereof are shown in FIG. 4.

### Experimental Example 1-4: Evaluation of activity of catalyst

In order to confirm the activity of the catalysts according to Examples 4 to 7 and Comparative Example, CO conversions (%) according to a temperature were measured. The results thereof are shown in FIG. 5.

Referring to the results of FIG. 2 according to the present invention, it was confirmed that the activity at 150°C was improved in the case of Example 2 in which the TiO₂ inorganic film of 10 cycles was applied.

In addition, referring to the results of FIG. 3, it was confirmed that the activity at 160°C was also improved. That is, it was confirmed that the activity was remarkably improved as compared to Comparative Example of Bare Pt/γ-Al₂O₃.

Referring to the results of FIG. 4 according to the present invention, it was confirmed that Example 2 in which the TiO₂ inorganic film of 10 cycles was applied showed high activity as compared to Comparative Example, and when exceeding 50 cycles, the activity similar to that of Comparative Example was provided.

Referring to the results of FIG. 5 according to the present invention, it was confirmed that, when the TiO₂ inorganic film of 10 to 100 cycles was applied, relatively high activity was shown. In particular, it was confirmed that, in the case of Pt/α-Al₂O₃, the activity was the highest at 50 cycles.

Therefore, according to the metal catalyst of the present invention, the inorganic film is deposited by controlling the ALD process, thereby providing improved activity of the catalyst. In particular, the present invention includes a step of inducing selective adsorption of reactants to a portion having a low coordination number on the surface of the catalyst, thereby maximally securing the interface between the catalyst and the reactant. This can be expected to improve the activity.

That is, high catalytic activity can be provided through the ALD process conditions that induce the interaction with the deposited inorganic film, that is, titania (TiO₂), while maximally securing the active sites of the platinum (Pt) catalyst. In addition, it is possible to provide an effect of providing different degrees of catalytic activity improvement by controlling the ALD process conditions as necessary.

While the present invention has been described by particular matters such as specific components and limited embodiments and drawings, this is provided only for helping the comprehensive understanding of the present invention. The present invention is not limited to the above-described embodiments, and it will be understood by those of ordinary skill in the art that various modifications and variations can be made thereto without departing from the scope of the present invention.

Therefore, it will be understood that the spirit of the present invention should not be limited to the above-described embodiments and the claims and all equivalent modifications fall within the scope of the present invention.

### INDUSTRIAL APPLICABILITY

According to the present invention, an inorganic film may be deposited according to an atomic layer deposition (ALD) process, thereby improving activity of a catalyst.

In particular, selective adsorption of a precursor may be induced to a portion having a low coordination number in a catalyst, thereby improving the interface with the catalyst surface and improving activity.

According to the present invention, different degrees of activity improvement may be provided according to ALD process conditions.

## Claims

1. A method for producing a metal catalyst having an inorganic film deposited thereon by means of an atomic layer deposition (ALD) process, the method comprising:
(a) injecting a precursor into a supported catalyst using ALD to induce selective adsorption of the precursor to a portion having a low coordination number on a surface of a catalyst;
(b) performing purging;
(c) depositing an inorganic film by injecting an oxidizing agent and reacting the oxidizing agent with the precursor selectively adsorbed on the surface of the catalyst; and
(d) performing purging.

2. The method of claim 1, wherein the catalyst in the step (a) is at least one selected from platinum (Pt), gold (Au), silver (Ag), copper (Cu), nickel (Ni), palladium (Pd), rhodium (Rh), and ruthenium (Ru).

3. The method of claim 1, wherein the supporting in the step (a) provides at least one selected from alumina, silica, zeolite, titania, zirconia, and carbon as a support.

4. The method of claim 1, wherein the precursor in the step (a) is at least one precursor selected from titanium (Ti), aluminum (Al), zinc (Zn), zirconium (Zr), and cerium (Ce).

5. The method of claim 1, wherein the inducing of the selective adsorption in the step (a) is controlled by adjusting an injection time, a substrate temperature, and a process cycle.

6. The method of claim 1, wherein the oxidizing agent in the step (c) is at least one selected from ultra-pure purified water, alcohol, ozone, nitrous oxide, and oxygen.

7. The method of claim 1, wherein an injection time of the injecting in the steps (a) and (c) is 0.5 seconds to 30 seconds.

8. The method of claim 1, wherein the injecting in the steps (a) and (c) is performed by injecting an inert gas as a carrier gas.

9. The method of claim 1, wherein the purging in the steps (b) and (d) is performed by injecting an inert gas.

10. The method of claim 1, wherein the purging in the steps (b) and (d) is performed at a pressure of 0.001 to 1 torr.

11. The method of claim 1, wherein an atomic layer is deposited by performing the method 1 to 100 cycles.

12. A metal catalyst having an inorganic film deposited thereon by means of an atomic layer deposition (ALD) process, the metal catalyst being produced by the method according to any one of claims 1 to 11.

13. The metal catalyst of claim 12, wherein a thickness of the inorganic film is 0.1 nm to 2 nm.

14. The metal catalyst of claim 12, wherein the metal catalyst is provided for a carbon monoxide oxidation reaction.
